# EUROPEAN PATENT APPLICATION

(11) **EP 4 226 816 A1**
(43) Date of publication of application: **16.08.2023**
(21) Application number: 22155939.6
(22) Date of filing: 09.02.2022
(51) Int. Cl.: A47J 27/00, A47J 36/02, B21D 51/22, C23C 14/50

(54) **BAKEWARE, COOKWARE AND/OR GRILLWARE ITEM, METHOD OF COATING A BAKEWARE, COOKWARE AND/OR GRILLWARE ITEM, CARRIER FOR A COATING DEVICE, AND COATING DEVICE**

(71) Applicant: IHI Hauzer Techno Coating B.V., 5928 LL Venlo (NL)
(72) Inventor: Immich, Philipp, 47661 Issum (DE); Doerwald, Dave, 6515 HP Nijmegen (NL); Jacobs, Ruud, 5912 Venlo (NL); Fransen, Geert-Jan, 6223 GX Maastricht (NL); Gelten, Marijn, 5644 TH Eindhoven (NL); Wemmenhove, Jan, 5491 XP Sint-Oedenrode (NL); Song, Xiaowei, 21176 Malmö (SE)
(74) Representative: Manitz Finsterwald Patent- und Rechtsanwaltspartnerschaft mbB

(57) **Abstract**

The invention relates to a bakeware, cookware and/or grillware item comprising a base, a heating side (14) arranged at a first side of the base (B), and a cooking side (12) arranged at a second side of the base (B), with the cooking side (12) being oppositely disposed to the heating side (14), wherein at least the cooking side (12) comprises a layer structure (LS) comprising at least a functional layer (FL), with the functional layer (FL) comprising a composition of Cr_{X}N_{1-X}, where 0.5 < X ≤ 0.95 and a hardness selected in the range of 10 to 30 GPa, and a thickness selected in the range of 0.1 to 5 µm. The invention further relates to a method of coating bakeware, cookware and/or grillware items, a carrier for a coating device (100) for coating bakeware, cookware and/or grillware items and a coating device.

## Description

The invention relates to a bakeware, cookware and/or grillware item comprising a base, a heating side arranged at a first side of the base, and a cooking side arranged at a second side of the base, with the cooking side being oppositely disposed to the heating side. The invention further relates to a method of coating bakeware, cookware and/or grillware items, to a carrier for a coating device for coating bakeware, cookware and/or grillware items, and to a coating device.

Bakeware, cookware and/or grillware is typically used to transfer heat from a source of energy to items of food in order to bake, fry, cook or grill the items of food. It is generally desirable that the containers used for baking, cooking and/or grilling have non-stick properties so that the items of food do not adhere to the respective container. It is further desirable that the surfaces of the containers can be washed readily, for example in a dish washer. It is further desirable that the cooking surface provides wear resistance to mechanical load applied on the surfaces that is for example created by the use of spatulas, knives, spoons etc. with the bakeware, cookware and/or grillware item.

Current state of the art non-stick coatings of bakeware, cookware and/or grillware comprise e.g. PTFE (e.g. Teflon) to form non-stick pans. Such coatings comprise materials which are no longer desirable in the food industry and are prone to being scratched rather easily. Moreover, these coatings cannot readily be used in a dish washer as the non-stick properties of these coatings also degrade with the number of times the container is heated, used and subsequently washed. Also, such coatings should not be heated beyond about 260 °C as they are prone to evaporate toxic fumes that can cause flu-like symptoms (polymer fume fever).

In view of the above it is an object of the present invention to provide a bakeware, cookware and/or grillware item comprising a cooking side that is more durable, at the same time less susceptible to the chemical environment of a dish washer, that has an increased lifetime of its non-stick properties and that can be produced cost efficiently.

This object is solved by a bakeware, cookware and/or grillware item in accordance with claim 1.

Such a bakeware, cookware and/or grillware item according to the invention comprises a base, a heating side arranged at a first side of the base, and a cooking side arranged at a second side of the base, with the cooking side being oppositely disposed to the heating side, wherein at least the cooking side comprises a layer structure comprising at least one functional layer, with the functional layer comprising a composition of Cr_{X}N_{1-X}, where 0.5 < X ≤ 0.95 and the functional layer having a hardness selected in the range of 10 to 30 GPa, and the functional layer having a thickness selected in the range of 0.1 to 5 µm.

In this connection it is noted that the expression "oppositely disposed" should be understood such that a main part of a surface of the cooking side faces away from a main part of a surface of the heating side. It does not necessarily mean that the whole surface of the cooking side, for example, has to be arranged in parallel to the whole surface of the heating side. Thus, when considering a frying pan, for example, the cooking side refers to the bottom of the pan as well as to its side walls which may be arranged at an angle relative to the heating side. Thus, the cooking side defines said part of the item that may come into contact with the food while cooking or frying it.

Hence, the cooking side of a bakeware, cookware and/or grillware item is the side on which the food is placed, i.e. the food contact side, which comprises a cooking surface and also inner side walls of a rim surrounding the cooking surface. The coatings discussed in the foregoing could either be provided solely on the cooking side or such that they cover both the cooking side and the inner side walls of the rim of the bakeware, cookware and/or grillware item or indeed such that the coatings cover all of the outer surfaces of the bakeware, cookware and/or grillware item.

In this connection it should be noted that the heating side is generally the side of the bakeware, cookware and/or grillware item where no food is in contact with the item, i.e. the non-food contact side.

It is further noted that the expression Cr_{X}N_{1-X} refers to a chemical compound comprising chromium, Cr, and nitrogen, N, and that the character X refers to a per-cental amount between said components of the chemical compound. As already mentioned above, CrₓN₁₋ₓ has proven to be very hard and extremely resistant to corrosion.

CrₓN₁₋ₓ structures have further surprisingly proven to have a comparatively high hardness such that surfaces coated with said material could become more durable to scratches. Additionally, such structures have additionally shown better anti-adhesive properties during their lifetime than commonly known non-stick coatings. To verify this, several experiments have been carried out such that it could be proven, for example, that a CrₓN₁₋ₓ coating can comprise anti-stick qualities that are within 80% of the anti-stick qualities of PTFE.

However, as the CrₓN₁₋ₓ coating is more durable compared to PTFE, the anti-stick qualities of CrₓN₁₋ₓ remain basically the same even after a long time while PTFE coatings lose their high anti-stick qualities relatively quick.

In this connection it is noted that further measurement techniques to evaluate the adhesion properties of a coating are, for example, a so-called scratch test according to ISO 20502 or a so called Rockwell test according to VDI 3198. These measurement techniques are commonly known in the art and widely used.

Moreover, CrₓN₁₋ₓ structures have been found to be less susceptible to chemical environments, such as the ones present in a dish washer, thereby increasing the lifetime of the products that are coated with such a layer.

Furthermore, as already mentioned above, frying pans and the like coated with CrₓN₁₋ₓ can be heated to high temperatures, i.e. above 260 °C, without risking to evaporate toxic fumes as it is for example the case with PTFE since at high temperatures the layer structure according to the invention forms a stable, and thus not dangerous, Chromium-oxide-layer.

The functional layer has further a hardness selected in the range of 10 to 30 GPa (according to ISO 14577) and a thickness selected in the range of 0.1 to 5 µm (according to ISO 1071-2). Coatings with such properties have been found to be advantageous in achieving the above objects.

The functional layer may further comprise at least 70 at% Cr and/or at least 5 at% N. Hence, it is possible that the layer structure only consists of CrₓN₁₋ₓ while at the same time it could also be possible that the structure comprises further elements such as transition metals (Group 4,5,6), e.g. Si, or elements from the main groups 3, 4 or 6, such as e.g. Aluminium, Carbon, Boron or Oxygen.

It may be advantageous if an amount of Si and C is selected in the range of 0.01 to 5 at%, preferably of 0.5 to 1.5 at%, respectively. It may further be advantageous if the total amount of said alloy elements is selected in the range of 0.01 to 2 at%.

According to another embodiment the layer structure can comprise one or more further layers, with said one or more layers comprising CrₓN₁₋ₓ with X selected in the range of 0.5 to 0.95. Thus, the layer structure can be formed by more than one layer.

According to another embodiment the layer structure can also comprise alloy elements, such as Si, C or O, since such alloy elements can further enhance the wear resistance. Furthermore, such alloy elements can also be used to change the colour of the layer structure.

The composition of a coating can be measured, for example, with energy dispersive x-ray spectroscopy which is a commonly known measurement technique for a person skilled in the art.

The functional layer may further have a thickness selected in the range of 0.3 to 5 µm, especially of 0.5 to 2 µm.

In this connection it is noted that the thickness of a coating layer can be measured with conventionally known measurement techniques such as x-ray fluorescence according to DIN ISO 3497.

Additionally or alternatively the thickness can also be measured with a so called Calo tester which is a simple and inexpensive piece of equipment used to measure the thickness of coatings. The Calo tester consists of a holder for the surface to be tested and a steel sphere of known diameter that is rotated against the surface by a rotating shaft connected to a motor whilst diamond paste is applied to the contact area. The sphere is rotated for a short period of time (less than 20 seconds for a 0.1 to 5 micrometre thickness) but due to the abrasive nature of the diamond paste this is sufficient time to wear a crater through thin coatings. An optical microscope is then used to take two measurements across the crater after the Calo test and the coating thickness is calculated using a simple geometrical equation t = xy/d, where t is the coating thickness, d is the diameter of the sphere, x is the difference between the radius of the crater and radius of the part of the crater at the bottom of the coating and x+y is the diameter of the crater. In this connection it is noted that the described Calo tester can be operated according to ISO 1071-2 standards.

With the above measurements it could also be proven that the thickness uniformity of the layer structure can be selected in the range of +/- 20%. In this connection it should be noted that the uniformity of the layer thickness may vary in dependence on the type of bakeware, cookware and/or grillware item that is coated, for example a "flat" frying pan may have thickness uniformity which is less than the above, i.e. below +/- 20% such as e.g. +/- 10%, and a wok pan may have a thickness uniformity greater than the above value, i.e. higher than +/- 20% such as e.g. +/-30%.

The functional layer can further have a hardness selected in the range of 12 to 27 GPa, especially of 15 to 25 GPa. The hardness of a material can be measured with the so called nano-indentation technique which is a known measurement technique according to ISO 14577.

According to another embodiment the chromium content may be at least 60 at%, preferably selected in the range between 70 and 90 at%. Further, the nitrogen content can be at least 5 at%, preferably selected in the range between 10 and 40 at%.

In this connection it is noted that the chromium and nitrogen content can also be chosen in dependence on one another.

According to a further embodiment a sum of the chromium and nitrogen content in the functional layer is at least 90 at%, preferably at least 95 at%. That is, the content of Cr_{X}N_{1-X} in the functional layer is at least 90 at%, preferably at least 95 at%. According to another embodiment functional layer can comprise a nanocrystalline structure, preferably a hexagonal nanocrystalline structure, preferably a P-31m hexagonal structure. This can for example be the case for Cr₂N structures which have proven to be one of the particularly advantageous embodiments for such layer structures as such a hexagonal nanocrystalline structure is hardly susceptible to chemical environments such that lifetime of the bakeware, cookware and/or grillware item according to the invention can be extended even if it is placed inside a dishwasher, for instance.

According to an embodiment the bakeware, cookware and/or grillware item can comprise a transition layer between the base and the functional layer, with the functional layer having the Cr_{X}N_{1-X} composition and the transition layer optionally being formed by reactive deposition with gradient of gas, such as nitrogen, and/or process parameter based gradient, preferably Bias or pressure, and/or a monolayer with fix composition like Cr or CrN, Titanium, Zirconium or other transition metals, with said metals having an addition of Nitrogen or Carbon. Such a transition layer can e.g. act as a bonding agent between the base and the functional layer.

According to another embodiment the layer structure comprises at least one monolayer of Cr_{X}N_{1-X} and the layer structure is formed by one of a monolayer, a multilayer and a gradient structure.

That is, if the layer structure can be formed as a monolayer, i.e. for example by only comprising one functional layer, the (chemical) composition of the layer structure is generally homogeneous and does not vary along its dimensions. In this connection it is noted that a layer or monolayer does not necessarily refer to a single atomic layer but can also refer to a layer made out of several or a plurality of atomic layers.

If, on the other hand, the layer structure is formed as a multilayer, at least its outermost layer is the functional layer comprising the Cr_{X}N_{1-X}. At least one of the other layers of the multilayer structure can comprise different materials such that it at least differs from the layer comprising Cr_{X}N_{1-X}. Additionally, further layers can be present which can optionally comprise further different materials.

According to another option the layer structure can be formed as a gradient structure such that its composition varies at least along its thickness such that the outermost layer, i.e. the functional layer, comprises Cr_{X}N_{1-X} while the innermost layer can e.g. only comprise Cr or another material such that the Cr_{X}N_{1-X} content gradually increases along the thickness of the layer structure.

According to a further embodiment the base can comprise a metal layer, in particular a metal layer selected from the group of members consisting of an aluminum layer, an aluminum alloy layer, an anodized aluminum layer, a cast aluminum layer, a copper layer, a copper alloy layer, a cast copper layer, an iron layer, an iron alloy layer, a cast iron layer, a stainless steel layer, a polished metal layer, a brushed metal layer, a sanded metal layer, a bead-blasted metal layer, a hammered metal layer and combinations of the foregoing. Such base materials lead to particularly good bakeware, cookware and/or grillware items that ensure a homogenous cooking temperature throughout the cooking side.

According to a further aspect the present invention relates to a method of coating bakeware, cookware and/or grillware items, such as the ones discussed herein, with the method comprising the following steps:
- placing at least one uncoated item, preferably a plurality of uncoated items, of the bakeware, cookware and/or grillware items in a vacuum chamber and evacuating said vacuum chamber,
- etching at least a cooking side of said one or more uncoated items; and
- coating said cooking side with a layer structure comprising at least one functional layer, with the functional layer comprising a composition of Cr_{X}N_{1-X},

where 0.5 < X ≤ 0.95 and the functional layer having a thickness selected in the range of 0.1 to 5 µm, by means of PVD, e.g. ARC, HIPIMS, pulsed or dc magnetron sputtering and/or combinations thereof.

Optionally, the at least one uncoated item can also be heated to a predetermined temperature before at least its/their cooking side is etched and/or coated.

Using this method bakeware, cookware and/or grillware items having the above specifications and advantages can be formed.

A temperature of said vacuum chamber may be regulated to a temperature in the range of 120 to 450°C, in particular of 160 to 200°C during said step of coating said cooking side with the layer structure. In this way particularly hard and durable layer structures can be formed.

A pressure in said vacuum chamber may further be regulated to a pressure of 10⁻² to 10⁻⁴ mbar, preferably of 10⁻² to 10⁻³ mbar.

According to another aspect the invention relates to a carrier for a coating device for coating bakeware, cookware and/or grillware items, with the bakeware, cookware and/or grillware items comprising a base, a heating side arranged at a first side of the base, and a cooking side arranged at a second side of the base, with the cooking side being oppositely disposed to the heating side. The carrier is further configured to hold a plurality of items such that a first group of the plurality of items faces away from a second group of the plurality of items thereby enabling the coating device to apply the coating from two or more different sides.

In this connection it is noted that the above mentioned groups of items may comprise either one or more items. The first and second groups can either comprise the same amount of items or a different amount.

With the carrier according to the invention it is possible to coat a large amount of items at the same time as the coating device can apply the coating from two or more different sides as the different groups of items face in different directions. Commonly known carriers for coating devices, on the other hand, usually hold all items in one plane such that the coating device can apply the coating only from one side.

In this connection it is noted that the expression "oppositely disposed" should be understood such that a main part of a surface of the cooking side faces away from a main part of a surface of the heating side. It does not necessarily mean that the whole surface of the cooking side, for example, has to be arranged parallel to the whole surface of the heating side. Thus, when considering a frying pan, for example, the cooking side refers to the bottom of the pan as well as to its side walls which may be arranged at an angle relative to the heating side. Thus, the cooking side defines said part of the item that may come into contact with the food while cooking or frying it. Consequently, the heating side is generally the side of the bakeware, cookware and/or grillware item where no food is in contact with the item, i.e. the non-food contact side.

Furthermore, it is noted that the coating that is applied by the coating device may comprise Cr_{X}N_{1-X}, where 0.5 < X ≤ 0.95, such as for example Cr₂N.

The carrier can further comprise a first and a second fixture frame respectively configured to hold the first and second groups of said plurality of items. Said fixture frames can be arranged such that the items held by said frames, i.e. the first and second group of items, face away from one another.

Additionally or alternatively the first and the second fixture frames may comprise a plurality of receiving structures formed within the first and second fixture frames. Said receiving structures can be configured to receive one of the first and second groups of the plurality of items. In particular, each receiving structure can receive one item at a time.

The first and the second fixture frames can further be connected to one another, preferably in a form fitting, force fitting and/or shape fitting manner, in particular by means of a screwed connection, a snap-fit connection, a snap lock connection, by means of a welded connection, a bonded connection and/or combinations of the foregoing. In some cases it might be advantageous when the first and second fixture frames are releasably connected to one another while in other cases it may be desired to have permanently connected fixture frames. The latter can even be designed as a single piece in order to lower the production costs of the frames.

In a further embodiment the carrier can comprise magnets configured to hold the items at their respective heating side, in particular inside of the receiving structures of one of the first and the second fixture frames. With the use of magnets the cookware, bakeware and/or grillware items can be attached and detached to the carrier, in particular to the receiving structures of the fixture frames, rather easily. At the same time such magnets can provide a good support for the items such that they can be safely held in place during the coating process.

Additionally or alternatively the carrier can comprise clamping means which may be combined with a kind of formfit to hold the items at their respective heating side. Additionally or alternatively the clamping means can also be combined with the magnets mentioned above.

In some embodiments the carrier can comprise one magnet per item to be held while in other cases it might be necessary to provide two or more magnets per item to be held.

Alternatively, it could also be possible to provide one single magnet that is configured to hold a whole group of items in place. Thus, it can be seen that the precise amount of magnets can be chosen freely depending on the items and/or the magnets to be used.

Each fixture frame of the carrier can also comprise at least one shielding plate for shielding parts of an interior of the respective fixture frame. In particular, said shielding plate can be configured to shield parts of the items that are held by the fixture frame such that, for example, only the cooking side is coated and not the outer walls and/or the heating side of the item.

Therefore, the shielding plate can for example be configured to shield the spaces between the respective receiving structures.

According to another aspect the invention relates to a coating device comprising a carrier according to the invention and wherein the coating device comprises at least one loading chamber for loading a plurality of uncoated items into the carrier, at least one etching chamber for etching at least the cooking side of the plurality of uncoated items, at least one coating chamber for coating at least the cooking side of the plurality of uncoated items, in particular by means of the method according to the invention, and at least one unloading chamber for unloading the plurality of items from the carrier and wherein the carrier is configured to move through the chambers.

Thus, the coating device according the invention may be designed as an inline coating system with a plurality of chambers through which the carrier can move. In order to be able to move the carrier it can, for example, comprise a trolley or can be placed on top of a conveyor belt or the like.

It may further be possible that the coating device comprises one or more swivel arms configured to move the carrier through the coating device.

In this connection it is also noted that the various chambers can also be grouped or summarized to less chambers such that one chamber can have several functions such as loading and etching.

Further benefits and advantageous embodiments of the invention will become apparent from the dependent claims, from the description and from the accompanying drawings.

Further embodiments of the invention are described in the following description of the Figures. The invention will be explained in the following in detail by means of embodiments and with reference to the drawing in which is shown:
- Fig. 1:: different views of a cookware, bakeware and/or grillware item;
- Fig. 2:: a perspective view of a carrier;
- Fig. 3:: a side view of the carrier of Fig. 2;
- Fig. 4:: a detailed perspective of the receiving spaces of the carrier;
- Fig. 5:: a sketch of a coating device; and
- Fig. 6:: a sketch of a layer structure.

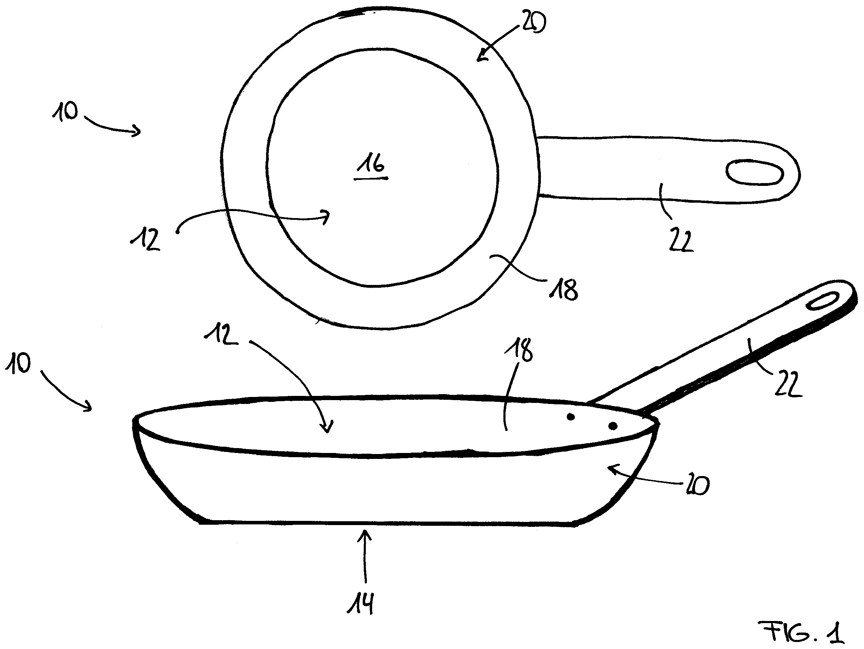

Fig. 1 shows a top view as well as side view of a cookware, bakeware and/or grillware item 10 (hereinafter only referred to as "item 10") according to the invention. The item 10 comprises a cooking side 12 as well as a heating side 14 which are oppositely disposed to one another. It can be seen in Fig. 1 that the cooking side refers to the inside of the item 10 which is why the cooking side 12 can either be defined as the inner bottom side 16 of the item 10 or as a combination of the bottom side 16 together with the inner surface 18 of the rim 20 of the item 10.

In this connection it is noted that the heating side 14 usually refers to the outer bottom side of the item 10 which is contact with the heating source. Generally, one could also define the heating side 14 as the complete outer surface of the item 10, thus also the outer surface of the rim 20.

Furthermore, it should also be obvious that the precise shape and size of the item 10 can be chosen freely and/or according to its precise application. Hence, the item 10 can for example comprise a rather "normal" round shape of a frying pan. Alternatively, the item 10 can also be designed as a square grillware item or a wok. There are almost no limitations when it comes to shape and size of item 10.

The item 10 can further comprise one or more handles 22 which is usually formed of plastic or any other material that is a poor heat conductor such that the handle does not heat up as much as the heating and the cooking side 12, 14 do when the item 10 is used.

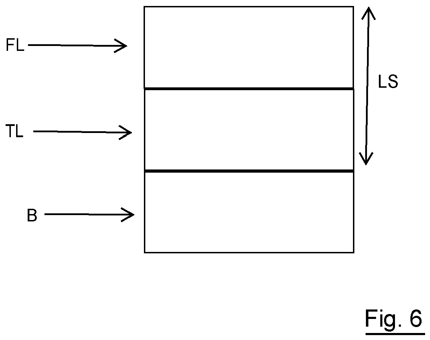

At least the cooking side 12 of item 10 comprises a layer structure LS (Fig. 6) that comprises at least one functional layer FL comprising Cr_{X}N_{1-X} such as for example Cr₂N. Said functional layer FL can further have a hardness selected in the range of 10 to 30 GPa, a thickness selected in the range of 0.1 to 5 µm.

Hence, the item 10 according to the invention comprises a functional layer FL at its cooking side 12 (and optionally also on any other given side) that is more durable to scratches, shows good anti-adhesive properties and is also less susceptible to chemical environments such as the ones present in a dish washer compared to commonly known non-stick coatings, thereby increasing the lifetime of the products that are coated with such a layer.

The functional layer FL comprises Cr_{X}N_{1-X}, where 0.5 < X ≤ 0.95, i.e. for example Cr₂N. In particular, the functional layer FL can completely be composed out of Cr_{X}N_{1-X}, wherein the chromium content of the functional layer FL can lie above 60 atomic percent (at%), preferably in a range of 70 to 90 at% and the nitrogen content can lie above 5 at%, preferably in a range of 10 to 40 at%. A sum of the chromium and nitrogen content in the functional layer can be at least 90 at%, preferably at least 95 at%.

As can further be seen in Fig. 6, it is also possible for the layer structure LS to comprise a further layer, such as a transition layer TL, arranged between the functional layer FL and a base B. The base B is usually formed by the material out of which the item 10 is made of, such as for example Aluminium.

As already mentioned earlier the further layer, e.g. the transition layer TL, can comprise Cr_{X}N_{1-X} or any other suitable material such that it at least differs from the functional layer FL comprising the Cr_{X}N_{1-X} content. Additionally, further layers can be present which can optionally comprise further different materials.

The layer structure LS can also be formed as a gradient structure such that its composition varies at least along its thickness such that the outermost layer, i.e. the functional layer FL, comprises Cr_{X}N_{1-X} while the innermost layer can e.g. only comprise Cr or another material such that the Cr_{X}N_{1-X} content gradually increases along the thickness of the layer structure.

In this connection it is noted that also further embodiments are possible regarding the further layers of the layer structure LS as long as the outermost layer, i.e. the functional layer FL, comprises the Cr_{X}N_{1-X} content.

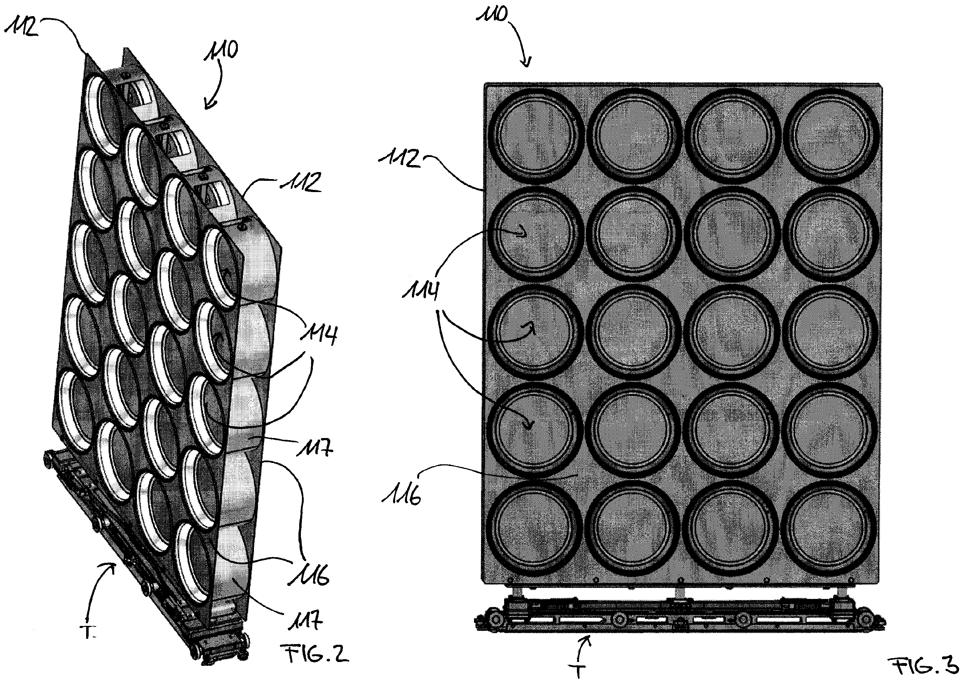

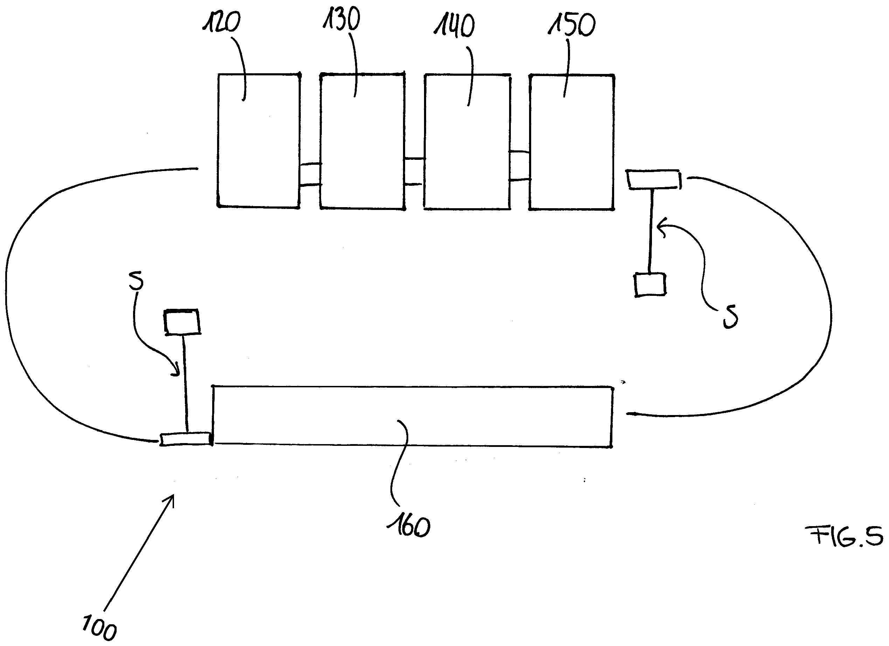

The invention further relates to a carrier 110 for a coating device 100 with which a plurality of items 10 can be coated with the above mentioned structure layer SL at the same time. Said carrier 110 can be seen in Figs. 2 to 4 whereas a sketch of the coating device 100 can be seen in Fig. 5.

In Figs. 2 and 3 the carrier 110 is depicted from two different angles such that the fixture frames 112 with their respective receiving structures 114 can be seen. The fixture frames 112 are arranged such that when items 10 are held by the frames 112 their respective cooking sides 12 are facing away from one another such that the coating device 100 can apply the coating, i.e. the layer structure comprising the functional layer from two or more sides.

Therefore, one could also think of arranging more than two fixture frames 112 such that the coating device 100 can apply the coating from three or more sides at the same time.

Each fixture frame 112 is configured to hold a group of items 10 of the plurality of items 10. The amount of group members of such a group can be chosen freely. Hence, such a group of items 10 can comprise only one, ten or even twenty group members. Generally, the group size is only limited by the size of the carrier 110, i.e. by its capacity.

The fixture frames 112 can either be designed as a single piece or can be held together by means of a screwed connection, a snap-fit connection, a snap lock connection, a welded connection, a bonded connection and/or combinations of the foregoing.

Furthermore, the carrier 110 comprises two shielding plates 116, one at each fixture frame 112 with which the spaces between the respective receiving structures 114 and thus an interior of the structure frames 112 can be covered. This way, uncoated items can be placed and fixed inside the receiving structures 114 such that only the cooking side 12 is coated with the layer structure while the outer surfaces together with the heating side 14 of the item 10 are covered by the shielding plate 116.

As one can see in Fig. 2, the shielding plate 116 can comprise further shielding structures 117 that are configured to cover the side walls, i.e. the rim 20, of the items 10. It is also possible that the shielding structures 117 are designed such that they additionally connect the two shielding plates 116 of the two fixture frames 112 with one another.

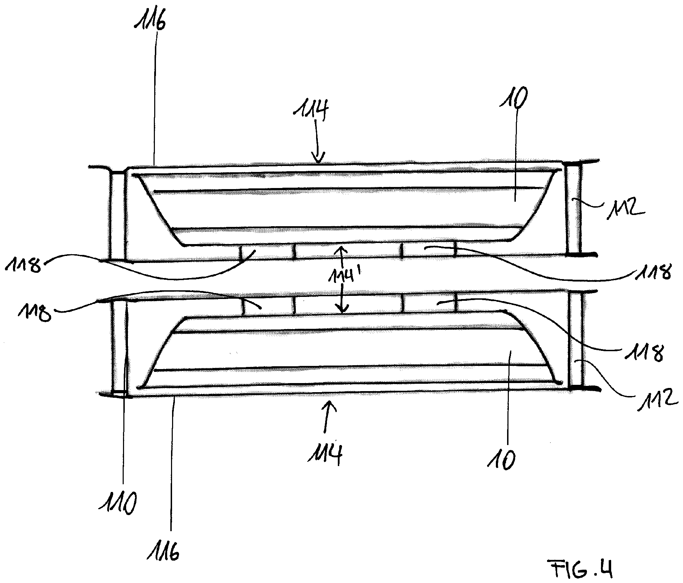

In order to hold the items 10 inside their respective receiving structures 114 the carrier comprises magnets 118 that are arranged at a bottom side 114' of each receiving space 114 such that they attract the heating side 14 of the item 10 to be held. In the embodiment shown in Fig. 4 each receiving structure 114 comprises two magnets 118 at its respective bottom side 114'. It could also be possible that only one magnet 118 or more than two magnets 118 is/are placed at the bottom side 114'. One could also think of placing only one single magnet 118 inside each fixture frame 112 which is configured to hold a whole group of items 10.

Figs. 2 and 3 furthermore show a trolley T that is arranged at one side of the carrier 110 such that the carrier 110 is configured to move through the different chambers 120, 130, 140, 150 of the coating device 100 that is depicted in Fig. 5.

The coating device 100 can be designed as a batch system as well as an inline system. The type of system may be chosen according to the production scale. For large production scales, for example, inline systems have proven to be advantageous. An embodiment which is designed as an inline system is further defined below:
The coating device 100 of Fig. 5 comprises a loading chamber 120, an etching chamber 130, a coating chamber 140 and an unloading chamber 150 through which the carrier 110 can move by means of its trolley T.

The whole device 100 or at least the four chambers 120, 130, 140 and 150 can be surrounded by a vacuum chamber (not depicted) such that a vacuum can be applied once the uncoated items are loaded to the carrier 110.

In this connection it is noted that it can also be possible that said vacuum can also be applied to each chamber separately such that no additional vacuum chamber is necessary.

Once the vacuum chamber (or each one of the above mentioned chambers) has been evacuated, the items 10 can then be heated to a predetermined temperature before their cooking sides 12 are being etched at the etching chamber 130. After the step of etching, the carrier 110 moves from the etching chamber 130 to the coating chamber 140 where the layer structure LS comprising the functional layer FL, i.e. the Cr_{X}N_{1-X} coating, is applied to the cooking sides 12 of the items 10 by means of a physical vapour deposition, PVD, e.g. a ARC, a HIPIMS process, pulsed or d.c. magnetron sputtering and/or combinations of the foregoing. As a last step the carrier 110 moves to the unloading chamber 150 where the coated items 10 are then unloaded from the carrier 110.

The coating device 100 further comprises an item loading station 160 where the new, uncoated items are being brought into the coating device 100 and thus loaded to the carrier 110 and where the finished, coated items 10 are unloaded from the carrier 110 and the coating device 100. The loading and/or unloading process of the items is usually carried out manually.

In order to move the carrier through the coating device 100, however, the device 100 can additionally comprise at least two swivel arms S that are configured to move the carrier 110 from one chamber to another, i.e. through the coating device 100.

Hence, the coating device 100 according to the invention can be configured as a completely automated inline coating device 100 with which a greater amount of items 10 can be coated at the same time compared to commonly known coating devices 100. This is mainly due to the use of the carrier 110 according to the invention with which at least two groups of items 10 can be coated at the same time, i.e. by applying the coating from two or more sides. Also, the special connection of the items 10 inside their respective receiving structures 114 that is given by the magnets 118 makes the loading and unloading step of the swivel arms S much easier and thus also much more efficient.

The items 10 that are coated with the coating device 100 according to the invention then comprise a layer structure LS comprising at least one functional layer FL at least on their cooking sides 12 that comprises Cr_{X}N_{1-X}, e.g. Cr₂N, which has proven to be more wear resistant and durable compared to commonly used coatings. Furthermore, Cr_{X}N_{1-X} comprises excellent anti-adhesive properties and is less susceptible to chemical environments.

In the following three examples for the above mentioned verifying experiments, i.e. comparison experiments, are given in the following table and descriptions:
The so called Nordtest method - NT CONS 17 - 1987-09 is one method used to evaluate the durability and long-term anti-stick properties of a device such as the items according to the invention. The test shows the anti-stick property after aging and abrasion. An item is aged by applying oil at the cooking side and heating it at 250 ± 5 °C for 1 hour. Afterwards, the item was abrased by steel wire whisks and butter/salt emulsion under 2 kg load at 180 ± 5 °C. After each 1000 cycles of abrasion, the anti-stick performance is evaluated by frying a pancake. A typical PTFE coating is usually raptured from 2000 to 2500 cycles of abrasion. In contrast to this the tested Cr_{X}N_{1-X} coating (245.20.03.05.001) remained intact up to 20000 cycles of abrasion and maintained its anti-stick performance in the pancake test.

Another durability evaluation is done through a so-called dishwashing test. Typical commercial PTFE coated cookware items are recommended to be handwashed due to their poor resistance to the environment in a dishwasher. Therefore, dishwashing tests were performed according to DIN EN 12875:2005-1. The Cr_{X}N_{1-X} coating (245.20.03.05.001) passed 250 cycles of dishwashing cycles.

Frying tests were performed to evaluate non-stick function of the items. Different greases/oils were used with a variety of food models. Grease/oil like butter, margarine, olive oil, rapeseed oil, sunflower oil, corn oil, rice oil, coconut oil, avocado oil and other liquid or solid form grease were used. Food models were chosen from research literature, standards and well received commercial tests. Pancakes and eggs are commonly used in above mentioned references. As such, they were used as food models in the non-stick function evaluation. The Cr_{X}N₁₋ₓ coating (245.20.03.05.001) revealed anti-stick qualities within 80% of the qualities of typical PTFE coatings. Also, a surprisingly a clear difference of the non-stick performance of a chemical composition for a layer with a Cr:N ratio with CrₓN₁₋ₓ could be observed.

The following table, for example, shows the test parameters and corresponding results of the different tests mentioned in this application for four different versions of CrN as well as one version of Cr2N:

**Table 1: test parameters and results of verifying experiments**

| **Batch number** | **Coating** | | | | | | **Thickness** | **Hardness** | **Adhe esion** | | 10 to 1, 10 is ref PTFE **frying test** |
|---|---|---|---|---|---|---|---|---|---|---|---|
| | | **Coating time** | **Cathode power** | **U bias** | **Argon** | **Reactive gas** | **Calo test** | **Nano indentation** | **Scratch test** | **Rockwell test** | |
| | | | | | | | **ISO 1071-2** | **ISO 14577** | **ISO 20502** | **VDI 3198** | |
| | | [min] | Cr [kW] | [V] | [sccm] | [sccm] | [µm] | [HV 15mN] | Lc2 [N] | [dB] | score |
| | | | | | | | | | | | |
| **240.20.03.05.00** | Cr2N | 60 | 12 | 150 | 400 | 60 | 1 | 2540 | 34 | 2 | 8 |
| **193.19.12.03.002** | CrN - Version 4 | 60 | 12 | 150 | 400 | 150 | 0,7 | 2300 | 36 | 2 | 6 |
| **193.19.05.31.001** | CrN - Version 3 | 72 | 1 × 10kW Cr | 100 | 400 | 150 | 0,8 | 1900 | 40 | 2 | 6 |
| **193.19.06.05.003** | CrN - Version 2 | 72 | 10 | 20 | 400 | 150 | 0,8 | 1800 | 50 | 1 | 4 |
| **193.18.05.01.001** | CrN - Version 1 | 60 | 2 × 6KW Cr | 50 | 400 | 200 | 1 | 1150 | 70 | 1 | **4** |

## Claims

1. A bakeware, cookware and/or grillware item comprising a base (B), a heating side (14) arranged at a first side of the base (B), and a cooking side (12) arranged at a second side of the base (B), with the cooking side (12) being oppositely disposed to the heating side (14),
wherein at least the cooking side (12) comprises a layer structure (LS) comprising at least one functional layer (FL), with the functional layer (FL) comprising a composition of Cr_{X}N_{1-X}, where 0.5 < X ≤ 0.95 and the functional layer (FL) having a hardness selected in the range of 10 to 30 GPa, and the functional layer (FL) having a thickness selected in the range of 0.1 to 5 µm.

2. The bakeware, cookware and/or grillware item according to claim 1,
wherein the layer structure (LS) comprises one or more further layers, with said one or more layers comprising Cr_{X}N_{1-X} with X selected in the range of 0.5 to 0.95.

3. The bakeware, cookware and/or grillware item according to claims 1 or 2, wherein the chromium content of the functional layer (FL) is at least 60 at%, preferably selected in the range of 70 and 90 at%, and the nitrogen content is at least 5 at%, preferably selected in the range of 10 and 40 at%.

4. The bakeware, cookware and/or grillware item according to any one of the preceding claims,
wherein a sum of the chromium and nitrogen content in the functional layer (FL) is at least 90 at%, preferably at least 95 at%.

5. The bakeware, cookware and/or grillware item according to one of the preceding claims,
wherein the functional layer (FL) comprises a nanocrystalline structure, preferably a hexagonal nanocrystalline structure, especially a P-31m hexagonal structure.

6. The bakeware, cookware and/or grillware item according to one of the preceding claims,
wherein the layer structure (LS) has a thickness selected in the range of 0.3 to 5 µm, especially of 0.5 to 2 µm.

7. The bakeware, cookware and/or grillware item according to at least one of the preceding claims,
wherein the layer structure (LS) has a hardness selected in the range of 12 to 27 GPa, especially of 15 to 25 GPa.

8. The bakeware, cookware and/or grillware item according to at least one of the preceding claims,
wherein the layer structure (LS) further comprises alloy elements, such as Si, preferably selected in the range of 0.01 to 5 at%, in particular of 0.5 to 1.5 at%, C, preferably selected in the range of 0.01 to 5 at%, in particular of 0.5 to 1.5 at%, O or transition metals (4,5,6) and/or from the main groups 3, 4 or 6, such as Aluminium, Oxygen or Boron,
in particular with a total amount of said alloy elements being selected in the range of 0.01 to 5 at%.

9. The bakeware, cookware and/or grillware item according to at least one of the preceding claims,
wherein the layer structure (LS) comprises a transition layer (TL) between the base and the functional layer (FL), with the functional layer (FL) having the Cr_{X}N_{1-X} composition and the transition layer (TL) optionally being formed by reactive deposition with gradient of gas, such as nitrogen, and/or process parameter based gradient, preferably Bias or pressure, and/or a monolayer with fix composition like Cr or CrN, Titanium, Zirconium or other transition metals, with said metals having an addition of Nitrogen or Carbon.

10. The bakeware, cookware and/or grillware item according to at least one of the preceding claims,
wherein the layer structure (LS) comprises at least one monolayer of Cr_{X}N₁₋x and wherein the layer structure (LS) is formed by one of a monolayer, a multilayer and a gradient structure.

11. The bakeware, cookware and/or grillware item according to at least one of the preceding claims,
wherein a crystal structure of the functional layer (FL) has a grain size between 1 and 30 nm, especially between 1 and 10 nm.

12. The bakeware, cookware and/or grillware item according to at least one of the preceding claims,
wherein the base (B) comprises a metal layer, in particular a metal layer selected from the group of members consisting of an aluminum layer, an aluminum alloy layer, an anodized aluminum layer, a cast aluminum layer, a copper layer, a copper alloy layer, a cast copper layer, an iron layer, an iron alloy layer, a cast iron layer, a stainless steel layer, a polished metal layer, a brushed metal layer, a sanded metal layer, a bead-blasted metal layer, a hammered metal layer and combinations of the foregoing.

13. The bakeware, cookware and/or grillware item according to at least one of the preceding claims,
wherein the functional layer (FL) comprises an amount of nitrogen selected in the range of 10 to 40 at%, at a temperature selected in the range of 450 to 550 K and a pressure selected in the range 0.1 to 1 Pa.

14. A method of coating bakeware, cookware and/or grillware items, in particular in accordance with at least one of the preceding claims, with the method comprising the following steps:
- placing at least one uncoated item, preferably a plurality of uncoated items, of the bakeware, cookware and/or grillware items (10) in a vacuum chamber and evacuating said vacuum chamber,
- etching at least a cooking side (12) of said one or more uncoated items; and
- coating said cooking side (12) with a layer structure (LS) comprising at least one functional layer (FL), with the functional layer (FL) comprising a composition of Cr_{X}N_{1-X}, where 0.5 < X ≤ 0.95 and the functional layer (FL) having a thickness selected in the range of 0.1 to 5 µm, by means of PVD, e.g. ARC, HIPIMS, pulsed or d.c. magnetron sputtering and/or combinations thereof.

15. A carrier for a coating device (100) for coating bakeware, cookware and/or grillware items, with the bakeware, cookware and/or grillware items (10) comprising a base (B), a heating side (14) arranged at a first side of the base (B), and a cooking side (12) arranged at a second side of the base (B), with the cooking side (12) being oppositely disposed to the heating side (14),
the carrier (110) being configured to hold a plurality of items (10) such that a first group of the plurality of items (10) faces away from a second group of the plurality of items (10) thereby enabling the coating device (100) to apply the coating from two or more different sides.

16. The carrier of claim 15,
wherein the carrier (110) comprises a first and a second fixture frame (112) respectively configured to hold the first and second groups of said plurality of items (10),
and/or wherein the first and the second fixture frames (112) comprise a plurality of receiving structures (114) formed within the first and second fixture frames (112).

17. The carrier of claim 15 or 16,
wherein the first and the second fixture frames (112) are connected to one another, preferably in a form fitting, force fitting and/or shape fitting manner, in particular by means of a screwed connection, a snap-fit connection or a snap lock connection, by means of a welded connection, a bonded connection and/or combinations of the foregoing.

18. The carrier of one of the preceding claims 15 to 17,
wherein the carrier (110) comprises magnets (118) configured to hold the items (10) at their respective heating side (14), in particular inside of the receiving structures (114) of one of the first and the second fixture frames (112).

19. The carrier of at least one of the preceding claims 15 to 18,
wherein each fixture frame (112) of the carrier (110) comprises at least one shielding plate (116) for shielding parts of an interior of the respective fixture frame (112).

20. A coating device comprising a carrier according to one of claims 15 to 19 and wherein the coating device (100) comprises at least one loading chamber (120) for loading a plurality of uncoated items into the carrier (110), at least one etching chamber (130) for etching at least the cooking side (12) of the plurality of uncoated items, at least one coating chamber (140) for coating at least the cooking side (12) of the plurality of uncoated items, in particular by means of the method according to claim 13, and at least one unloading chamber (150) for unloading the plurality of items (10) from the carrier (110) and wherein the carrier (110) is configured to move through the chambers (120, 130, 140, 150),
in particular with the carrier (110) being provided transportation means, such as a trolley (T) arranged at one end of the carrier (110) that is configured to transport the carrier (110) through said chambers (120, 130, 140, 150).
